Europäisches Patentamt

European Patent Office

Office européen des brevets

(11) Publication number: 0 223 475
A2

# (12) EUROPEAN PATENT APPLICATION

(21) Application number: 86308541.1

(22) Date of filing: 03.11.86

(51) Int. Cl.⁴ H01L 23/36

(30) Priority: 06.11.85 GB 8527372

(43) Date of publication of application:
27.05.87 Bulletin 87/22

(84) Designated Contracting States:
DE FR

(71) Applicant: THE M-O VALVE COMPANY
LIMITED
Brook Green Works
Hammersmith London, W6 7PE(GB)

(72) Inventor: Taylor, Eric Albert
7 Roy Grove
Hampton Middlesex TW12 3DN(GB)

(74) Representative: Dolwin, John Davison
Central Patent Department Wembley Office
The General Electric Company, p.l.c. Hirst
Research Centre East Lane
Wembley Middlesex HA9 7PP(GB)

(54) Microcircuit packaging member.

(57) A packaging member for microcircuits comprises a base element (1) having a projecting area (2) divided by intersecting slots (3) into teeth-like projections. A frame element (4) surrounds the base element (1) and defines a space in which a microcircuit can be housed with its substrate in contact with the teeth-like projections. The latter are made from a ductile material such as copper with high thermal conductivity. The nature of the base element enables the package to withstand thermal stress more easily.

Fig.2.

EP 0 223 475 A2

## Microcircuit Packaging Member

The present invention concerns packaging for hybrid microcircuits.

One problem with the packaging of microcircuits is that the requirement for power dissipation can cause unacceptable temperature rises.

Efforts to solve this problem have evolved in two main directions. In the first of these directions the package base to which the microcircuits are attached and through which the majority of the extraneous heat must pass has been constructed of copper, this material being chosen for its high thermal conductivity and related low cost properties. Compared with the Iron-Nickel-Cobalt alloy material from which standard microcircuit packages are made, copper exhibits 23 times the heat conductivity.

In such packages the microcircuit is attached typically by soldering the substrate on which the circuit is developed directly to the copper base of the package. This gives rise to further difficulties. The substrate is generally of Alumina ceramic which has a coefficient of expansion very different from that of copper, giving rise to distortion problems due to bimetallic action in cooling from the soldering operation. This is most noticeable if the copper base of the package is soft due to its having been annealed in high temperature brazing operations such as may be used in sealing side frames to it in the course of package manufacture. The provision of glass insulated lead-through seals through said side frame also has a softening effect on the copper base since these may be inserted at temperatures above the annealing temperature for copper. Even if methods are devised to overcome these softening operations to leave the package with a work hardened copper base so that no distortion to it occurs in the subsequent alumina substrate attachment operation other faults occur. These can range from broken substrates to detached substrates dependent upon the type of solder used to attach the substrate to the copper package base and upon the extent and number of any heat cycles to which the packaged circuit may be subject.

The second direction of effort to deal with heat dissipation problems is found in the attempts to meet the disadvantages of the first method. One attempt has been to replace the copper base with one of a lower thermal coefficient of expansion to match that of the alumina substrate with attendant loss of thermal conductivity. This approach typifies the other direction in which power packages for microcircuits have evolved. Another has been to mount the microcircuits on a number of smaller substrates to reduce the aggregate strain on any particular part of the alumina-solder-copper sandwich. This approach carries cost penalties in circuit manufacture and additional interconnections.

The present invention has for an object to provide improved packaging for microcircuits which reduces at least some of the above disadvantages.

Accordingly from one aspect the present invention consists in a packaging member comprising a base of high thermal conductivity ductile material and having a plurality of separate teeth projecting therefrom, a frame member surrounding the base element so as to define a space within which a microcircuit can be housed with its substrate located on the teeth of the base, and a lid member for mounting on the frame.

Preferably at least the teeth of the base member are of copper or of a material having a high proportion of copper. The frame may be integral with the base but on the other hand may be of a material of lower thermal conductivity than the base such as steel or stainless steel. In either case the frame may have a plurality of holes through which leads may pass for connection to a microcircuit housed within the package.

In order that the present invention may be more readily understood, an embodiment thereof will now be described by way of example and with reference to the accompanying drawings, in which

Figure 1 is an exploded perspective view of a package for a microcircuit, and

Figure 2 is a section through part of a package of the type shown in Figure 1 with a bonded substrate.

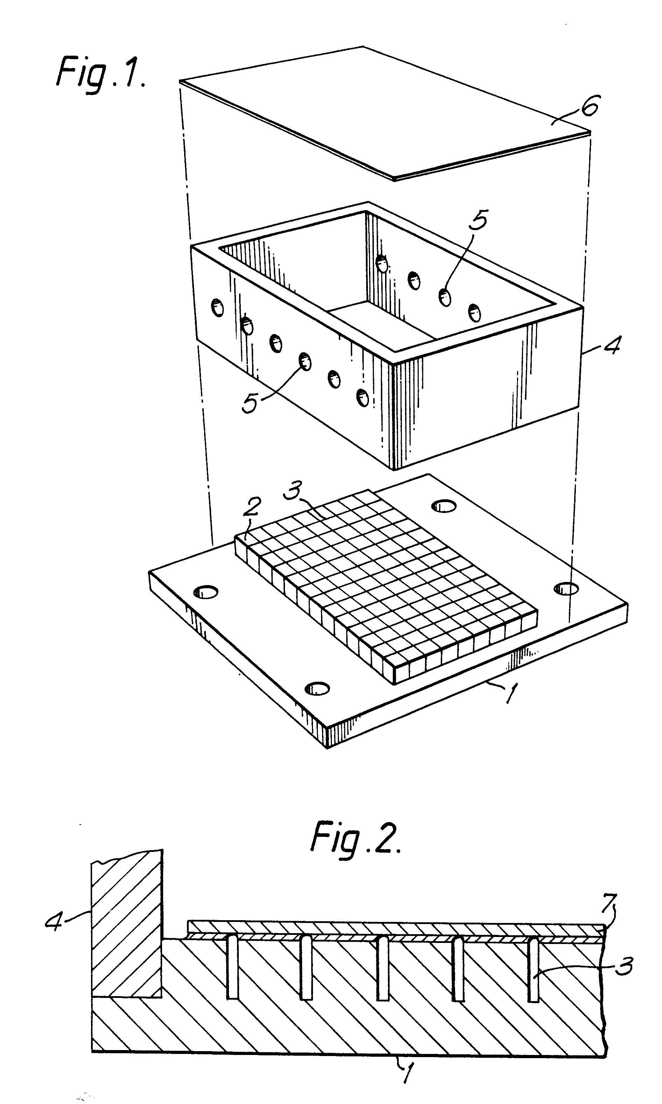

Referring to Figure 1 of the drawings, this shows a base 1 which is made of copper and which is stepped so that a rectangular portion 2 stands proud. This portion 2 is slotted with intersecting slots 3 so that it provides a dentate surface.

A rectangular frame 4 is made from steel or stainless steel and is so dimensioned that it can fit over the raised portion 2 to allow the base 1 and the frame 4 to be brazed together without recourse to external alignment fixtures. The frame 4 has a number of holes 5 through which connecting leads (not shown) can pass to be connected to appropriate pins on a conventional microcircuit (not shown) which is to be housed within the package. The leads can be sealed in the holes by glass. The materials of the leads and the composition of glass seals being so selected that hermetic seals are produced by the well-known matched expansion or "compression" sealing methods.

The actual package is completed by a lid 6 which can be stepped or plain and which is of the same material as the frame 4. The lid 6 can be secured to frame 4 in one of a number of conventional ways.

Referring now to Figure 2 this shows the base 1 brazed to frame 4. Furthermore a substrate 7 of a microcircuit has been brazed to the dentate surface of the package base 1.

It will be appreciated that the slots 3 in base portion 2 extend at right angles to one another. However the dentate nature of the top surface of this portion can also be provided with other slot configurations.

Furthermore it is possible for the frame 4 to be integral with base 1 without recourse to brazing the two parts together. In such a case a thin sealing ring may be hermetically sealed to the top of the frame. Also the walls of the slots defining the dentate surface need not be planar. It will also be appreciated that the size of the tops of the teeth of the dentate surface, their depth and the size of the gaps between them will be varied to suit the nature and the thickness of the substrate which is to be accommodated, the brazing medium used to attach the substrate and the maximum temperature excursion that the final packaged microcircuit must withstand in operation.

In action, the dentate surface is so broken as to permit the differential contraction stresses set up in cooling down after substrate soldering to be accommodated locally over the individual tooth areas without rupture or major distortion occurring. Since each tooth is by nature soft and ductile it easily yields into the surrounding spaces and thus the aggregate stress between substrate and package base is considerably reduced. In order to provide the above facility the slots occupy a relatively small fraction of the total surface area of the base and hence do not reduce the thermal conductivity by more than this fraction.

## Claims

1. A packaging member for housing hybrid microcircuits, comprising a base element (1) and a frame element (4) surrounding said base element and defining a space within which a microcircuit can be housed, and characterised in that the base element (1) is formed with a plurality of teeth-like elements (2, 3) which extend upwardly therefrom and are made from a ductile material having high thermal conductivity whereby the substrate of said microcircuit can be located on said teeth-like elements.

2. A packaging member as claimed in Claim 1, and characterised in that said ductile material contains a high proportion of copper.

3. A packaging member as claimed in Claim 1 or Claim 2, and characterised in that said frame element (4) is of steel.

4. A packaging member as claimed in any one of the preceding claims and characterised in that said teeth-like projecting elements are formed by an array of intersecting slots.

Fig.1.

6

5

5

4

2

3

1

Fig.2.

4

7

3

1